(19) Europäisches Patentamt
European Patent Office
Office européen des brevets

(11) **EP 3 631 589 B1**

(12) **FASCICULE DE BREVET EUROPEEN**

(45) Date de publication et mention de la délivrance du brevet:
**07.07.2021 Bulletin 2021/27**

(21) Numéro de dépôt: **18735645.6**

(22) Date de dépôt: **23.05.2018**

(51) Int Cl.:
**G05B 19/4093** *(2006.01)*    **B29C 64/00** *(2017.01)*

(86) Numéro de dépôt international:
**PCT/FR2018/051225**

(87) Numéro de publication internationale:
**WO 2018/220313 (06.12.2018 Gazette 2018/49)**

(54) **DISPOSITIF DE TRAITEMENT DE DONNEES POUR LA GENERATION DE MICROSTRUCTURES A PROPRIETES ELASTIQUES ORTHOTROPIQUES**

DATENVERARBEITUNGSVORRICHTUNG ZUR ERZEUGUNG VON MIKROSTRUKTUREN MIT ORTHOTROPEN ELASTISCHEN EIGENSCHAFTEN

DATA PROCESSING DEVICE FOR GENERATING MICROSTRUCTURES WITH ORTHOTROPIC ELASTIC PROPERTIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.06.2017 FR 1754866**

(43) Date de publication de la demande:
**08.04.2020 Bulletin 2020/15**

(73) Titulaire: **INRIA Institut National de Recherche en Informatique et en Automatique**
**78150 Le Chesnay (FR)**

(72) Inventeurs:
• **MARTINEZ, Jonas**
**54000 Nancy (FR)**
• **LEFEBVRE, Sylvain**
**54840 Velaine en Haye (FR)**
• **DUMAS, J r mie**
**13710 Fuveau (FR)**
• **SONG, Haichuan**
**Liaoning 12200 (CN)**

(74) Mandataire: **Cabinet Netter**
**36, avenue Hoche**
**75008 Paris (FR)**

(56) Documents cités:
**FR-A1- 3 038 254    US-A1- 2014 324 204**

**Description**

L'invention concerne le domaine des objets présentant des propriétés élastiques orthotropiques et en particulier la fabrication de ces objets par fabrication additive ou autre.

De nombreux travaux ont abordé la génération de structures permettant d'obtenir des objets présentant une élasticité variable. Ces travaux utilisent le principe d'une application d'un motif à petite échelle (microstructure) dont l'étude à grande échelle permet de valider les caractéristiques structurelles. Ainsi, un objet présentant une élasticité variable peut être fabriqué en réalisant plusieurs sous objets basés sur des motifs différents.

Cependant, ce type d'approche est complexe à mettre en œuvre dans le contexte de la fabrication additive car cette dernière impose des contraintes de fabrication fortes dépendant de la technologie (continuité verticale dans le cas du dépôt par couche, ou absence de poche dans le cas de l'utilisation de poudres). De plus, ce genre de technique génère des objets informatiques (maillages ou volumes) extrêmement volumineux, ce qui pose des problèmes avec les machines de fabrication additive actuelles.

La Demanderesse a proposé dans la demande de brevet française FR1652497 un dispositif fabriquant basé sur la génération de mousses isotropiques de Voronoï permettant d'obtenir une grande gamme d'élasticité et de varier cette élasticité progressivement au sein du volume d'une pièce. Cependant, cette approche ne peut pas produire une élasticité qui, en un point donné, est différente selon la direction des efforts : l'élasticité est nécessairement isotropique, c'est à dire la même quelle que soit la direction des efforts en un point local. Il n'est donc pas possible de produire un objet dont l'élasticité est modulable selon certaines directions, par exemple un cube qui soit plus rigide verticalement que dans le plan horizontal.

Ces problèmes se retrouvent également lorsque l'on cherche à usiner ces objets par d'autres méthodes, que ce soit par moulage ou par extrusion.

Le document FR 3 038 254 A1 divulgue un procédé pour traiter des données caractérisant un objet à réaliser par fabrication additive, dans lequel la surface de l'objet est décomposée en voxels indiquant un emplacement plein ou vide et reliés par des arêtes pondérées fonction de la distance séparant deux voxels reliés.

L'invention vient améliorer la situation. À cet effet, l'invention propose un dispositif de traitement de données pour fabrication de mousse, comprenant une mémoire agencée pour recevoir des données d'emplacement désignant un emplacement et un élément de volume contenant cet emplacement, et un générateur agencé pour déterminer des données de fabrication additive indiquant si un emplacement associé à des données d'emplacement est vide ou plein. La mémoire est agencée pour recevoir des données de densité, des données de déformation et des données de rayon.

Le générateur est agencé pour calculer, pour un emplacement donné désigné par des données d'emplacement, des données de graines de branche désignant des emplacements de graines de branches d'un jeu de graines de branches associé à l'emplacement donné, pour déterminer lesdits emplacements de graines de branche dans une pluralité d'éléments de volumes comprenant l'élément de volume contenant l'emplacement donné d'une part et des éléments de volumes sélectionnés dans un voisinage de l'élément de volume contenant l'emplacement donné d'autre part, chaque élément de volume recevant un nombre de graines de branche tiré de données de densité associées à cet élément de volume, pour calculer une mesure entre une première graine de branche et une deuxième graine de branche à partir de la distance entre l'emplacement de la première graine de branche d'une part et la deuxième graine de branche d'autre part, en pondérant cette distance en fonction de données de déformation associées à la première graine de branche et à la deuxième graine de branche, pour sélectionner au moins deux graines de branches pour chaque graine de branche, de sorte que ces au moins deux graines de branches sont les voisins les plus proches selon la mesure calculée par le générateur (4, 10), et pour définir des données de fabrication indiquant qu'un emplacement est plein lorsque la distance entre ledit emplacement et sa projection sur une des branches reliant chaque graine de branche à ses voisins les plus proches est inférieure à une distance tirée des données de rayon.

Dans d'autres modes de réalisation, le dispositif pourra présenter une ou plusieurs des caractéristiques supplémentaires suivantes :

- le générateur est outre agencé pour calculer la mesure entre une première graine de branche et une deuxième graine de branche en la pondérant en fonction d'un référentiel associé aux données de déformation,
- le générateur est agencé pour sélectionner les voisins les plus proches d'une graine de branche donnée parmi un sous-ensemble de graines de branches qui exclut les graines de branche dont les emplacements sont situés à une distance de l'emplacement de la graine de branche donnée supérieure à un seuil tiré des données de déformation et du nombre de voisins les plus proches recherchés,
- le générateur est agencé pour allouer les graines de branche de manière déterministe au sein de chaque élément de volume,
- le générateur est agencé pour déterminer lesdits emplacements de graines de branche en divisant chaque élément de volume de la pluralité d'éléments de volume en un ou plusieurs sous-éléments de volume dont le nombre est calculé à partir des données de densité et du volume de chaque élément de volume, en déterminant de manière pseudo-aléatoire en fonction des données d'emplacement et des données de densité des sous-éléments de volume recevant une graine de branche, et en déterminant de façon pseudo-aléatoire dans chaque sous-élément de volume recevant une graine de branche des données de graine de branche désignant un emplacement dans ce sous-élément de volume,

- le générateur est un modélisateur agencé pour recevoir un triplet associant des données de densité, des données de déformation et des données de rayon, pour déterminer un jeu de données de fabrication additive pour un objet de forme sensiblement cubique à partir de ce couple, et pour appliquer une méthode d'homogénéisation pour en tirer une donnée de tenseur,

- le modélisateur est agencé, pour un triplet donné, pour déterminer plusieurs jeux de données de fabrication additive en faisant varier les déterminations pseudo-aléatoires, et pour réaliser une moyenne des données de tenseur pour le triplet donné, et

- le générateur est un constructeur agencé pour recevoir des données d'objet définissant la forme d'un objet à produire par fabrication additive et comprenant des données de tenseur associées à des emplacements désignés par les données d'objet, et, pour certains au moins des emplacements des données d'objets, pour déterminer des données de déformation, des données de référentiel, des données de rayon et des données de densité à partir des données de tenseur associées, et pour déterminer des données de fabrication additive correspondantes.

L'invention concerne également un procédé de fabrication d'une mousse orthotropique qui comprend les opérations suivantes :

- recevoir des données d'objet associant des données d'emplacement et des données de tenseur, les données de tenseur étant associées à des données de densité, des données de rayon et des données de déformation,

- déterminer des emplacements de graines de branche dans une pluralité d'éléments de volume, le nombre de graines de branche dans un élément de volume donné étant déterminé à partir des données de densité associées aux emplacements de l'élément de volume donné,

- pour chaque graine de branche, calculer une pluralité de mesures entre cette graine de branche en tant que première graine de branche d'une part et une deuxième graine de branche d'autre part, la deuxième graine de branche étant choisie pour chaque mesure parmi les autres graines de branche, la mesure étant calculée à partir de la distance entre l'emplacement de la première graine de branche d'une part et la deuxième graine de branche d'autre part, en pondérant cette distance en fonction de données de déformation associées à la première graine de branche et à la deuxième graine de branche,

- sélectionner au moins deux graines de branches pour chaque graine de branche, de sorte que ces au moins deux graines de branches sont les voisins les plus proches dans la pluralité de mesures calculées pour chaque graine, et

- définir des données de fabrication indiquant qu'un emplacement donné est plein lorsque la distance entre ledit emplacement donné et sa projection sur une des branches reliant chaque graine à ses voisins les plus proches est inférieure à une distance tirée de données de rayon, et

- fabriquer une mousse suivant les emplacements pleins définis.

Dans diverses variantes le procédé peut présenter une ou plusieurs des caractéristiques suivantes :

- la mesure entre une première graine de branche et une deuxième graine de branche est pondérée en fonction d'un référentiel associé aux données de déformation,

- pour sélectionner les voisins les plus proches d'une graine de branche donnée, la pluralité de mesures est calculée avec un sous-ensemble de graines de branches qui exclut les graines de branche dont les emplacements sont situés à une distance de l'emplacement de la graine de branche donnée supérieure à un seuil tiré des données de déformation et du nombre de voisins les plus proches recherchés,

- lequel lesdits emplacements de graines de branche sont déterminés de manière déterministe,

- lesdits emplacements de graines de branche sont déterminés en divisant chaque élément de volume de la pluralité d'éléments de volume en un ou plusieurs sous-éléments de volume dont le nombre est calculé à partir des données de densité et du volume de chaque élément de volume, en déterminant de manière pseudo-aléatoire en fonction des données d'emplacement et des données de densité des sous-éléments de volume recevant une graine de branche, et en déterminant de façon pseudo-aléatoire dans chaque sous-élément de volume recevant une graine de branche des données de graine de branche désignant un emplacement dans ce sous-élément de volume, et

- l'opération de fabrication de mousse est réalisée par fabrication additive.

D'autres caractéristiques et avantages de l'invention apparaîtront mieux à la lecture de la description qui suit, tirée d'exemples donnés à titre illustratif et non limitatif, tirés des dessins sur lesquels :

- la figure 1 représente un diagramme schématique d'un dispositif selon invention,
- la figure 2 représente un exemple de mise en œuvre d'une fonction par le modélisateur de la figure 1,
- la figure 3 représente un exemple d'une fonction mise en œuvre par le modélisateur et le constructeur de la figure 1 pour calculer des graines de branche,
- la figure 4 représente un exemple d'une fonction mise en œuvre dans la fonction de la figure 3,
- la figure 5 représente une fonction mise en œuvre par le dispositif de la figure 1 pour imprimer un objet,
- la figure 6 représente un exemple de graphe d'élasticités obtenues dans le cadre de l'invention, et
- la figure 7 représente un exemple d'un objet fabriqué par le dispositif de l'invention, sous diverses contraintes.

Les dessins et la description ci-après contiennent, pour l'essentiel, des éléments de caractère certain. Ils pourront donc non seulement servir à mieux faire comprendre la présente invention, mais aussi contribuer à sa définition, le cas échéant.

La présente description est de nature à faire intervenir des éléments susceptibles de protection par le droit d'auteur et/ou le copyright. Le titulaire des droits n'a pas d'objection à la reproduction à l'identique par quiconque du présent document de brevet ou de sa description, telle qu'elle apparaît dans les dossiers officiels. Pour le reste, il réserve intégralement ses droits.

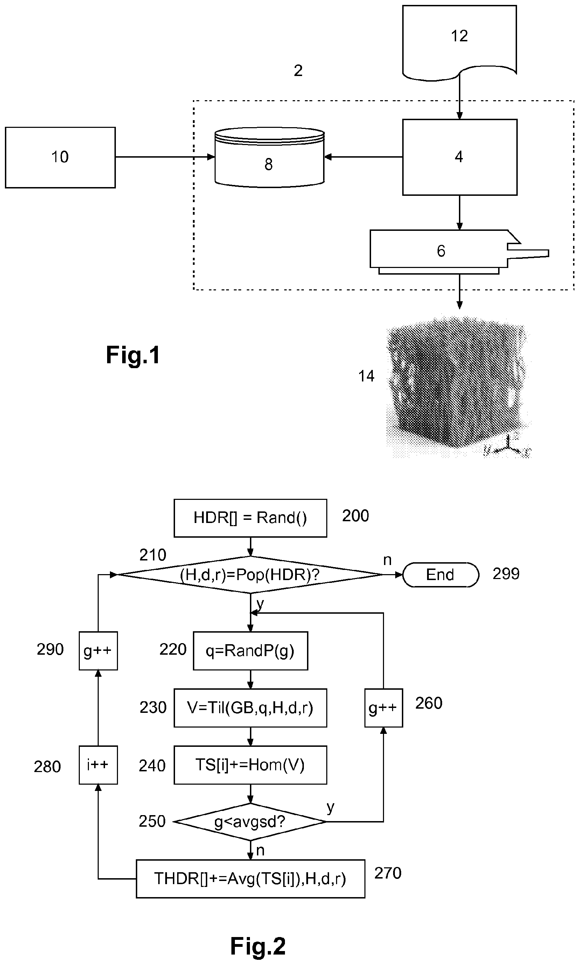

La figure 1 représente un dispositif 2 selon l'invention dans son environnement. Le dispositif 2 comprend un constructeur 4, une imprimante 6 et une mémoire 8. Dans l'exemple décrit ici, le dispositif 2 comprend également un modélisateur 10 dont le fonctionnement sera décrit ci-après.

Dans le cadre de l'invention, la mémoire 8 peut être tout type de stockage de données propre à recevoir des données numériques : disque dur, disque dur à mémoire flash (SSD en anglais), mémoire flash sous toute forme, mémoire vive, disque magnétique, stockage distribué localement ou dans le cloud, etc. Les données calculées par le dispositif peuvent être stockées sur tout type de mémoire similaire à la mémoire 8, ou sur celle-ci. Ces données peuvent être effacées après que le dispositif ait effectué ses tâches ou conservées.

Les données stockées dans la mémoire 8 comprennent des n-uplets qui associent un tenseur orthotropique, des données de déformation, une densité et un rayon. Dans l'exemple décrit ici, ces n-uplets sont calculés par le modélisateur 10. En variante, ils pourraient être obtenus différemment. Dans l'exemple décrit ici, les tenseurs orthotropiques associent un repère définissant deux ou trois axes, des valeurs d'élasticité selon chaque axe du repère, et optionnellement un ou deux coefficients de Poisson. Dans l'exemple décrit ici, les données de déformation comprennent autant de valeurs que les tenseurs orthotropiques comprennent d'axes. Comme on le verra plus bas, les données de déformation, la densité et le rayon permettent de produire une mousse ayant les propriétés orthotropiques du tenseur orthotropique du n-uplet auquel cet ensemble de données est associé. Les données stockées dans la mémoire 8 pourraient également être agencées sous une autre forme que des triplets ou des n-uplets.

Le constructeur 4 et le modélisateur 10 sont des éléments accédant directement ou indirectement à la mémoire 8. Ils peuvent être réalisés sous la forme d'un code informatique approprié exécuté sur un ou plusieurs processeurs. Par processeurs, il doit être compris tout processeur adapté aux calculs décrits plus bas. Un tel processeur peut être réalisé de toute manière connue, sous la forme d'un microprocesseur pour ordinateur personnel, d'une puce dédiée de type FPGA ou SoC (« system on chip » en anglais), d'une ressource de calcul sur une grille, d'un microcontrôleur, ou de toute autre forme propre à fournir la puissance de calcul nécessaire à la réalisation décrite plus bas. Un ou plusieurs de ces éléments peuvent également être réalisés sous la forme de circuits électroniques spécialisés tel un ASIC. Une combinaison de processeur et de circuits électroniques peut également être envisagée.

Le dispositif 2 reçoit des données d'objet 12 Les données d'objet 12 comprennent une description de la forme tridimensionnelle qui est souhaitée pour l'objet à imprimer, ainsi qu'une indication d'orthotropie sous la forme d'un champ de tenseurs d'orthotropie variant au sein de l'objet, de manière continue ou discontinue.

À partir des données d'objet 12, le constructeur 4 accède à la mémoire 8 et détermine un n-uplet pour chaque partie distincte de l'objet. Ensuite, à partir de la forme tridimensionnelle recherchée et des données obtenues, le constructeur 4 détermine les emplacements de chaque couche devant être imprimés et commande l'imprimante 6 pour produire en sortie un objet 14 qui présente des caractéristiques d'élasticité et la forme tridimensionnelle dictées par les données d'objet 12. Le constructeur 4 peut également déterminer la totalité de l'objet 14 en parallélisant les calculs pour chaque partie distincte, et imprimer l'objet 14 selon diverses méthodes. La génération de la mousse interne à l'objet peut donc être procédurale ou pas, c'est à dire que la géométrie de la mousse peut être intégralement pré-calculée, ou bien générée à la volée pendant le processus d'impression (procédurale), limitant ainsi fortement la quantité de mémoire nécessaire pour stocker la pièce.

Les objets réalisés au moyen du dispositif 2 peuvent être qualifiés de « mousses orthotropiques ». En effet, l'invention a été conçue en vue de produire des objets dont le comportement élastique est orthotropique - ce qui inclut et généralise l'isotropie.

Pour cela, le constructeur 4 détermine pour chaque couche de l'objet des graines de branche dont la quantité est dictée par la densité du triplet tiré de la mémoire 8 à partir des données d'objet 12 pour la portion de l'objet en cours d'impression.

Ensuite, les graines de la portion considérée sont parcourues afin de relier chaque graine à ses k graines voisines les plus proches, la proximité étant tirée du champ de mesures défini à partir des vecteurs de déformations locaux. La distance utilisée pour le calcul de proximité est donc biaisée par les données de déformation, ce qui suscite le comportement élastique orthotropique. Enfin, chaque point de cette portion pouvant être imprimé est considéré comme plein s'il se situe à une distance choisie des branches et vide sinon, la distance choisie correspondant au rayon du triplet tiré de la mémoire 8 à partir des données d'objet 12. La notion de distance doit être ici interprétée au sens large, il est donc possible de modifier la distance pour modifier la géométrie des arêtes de la mousse orthotropique. Ainsi, le constructeur 4 construit de proche en proche des branches qui présentent chacune une épaisseur choisie pour conférer à la structure une élasticité choisie.

La figure 2 représente un exemple d'une fonction mise en œuvre par le modélisateur 10 pour établir les triplets valeur d'élasticité, densité et rayon. Pour cela, le modélisateur 10 génère une grande quantité de cubes de mousses orthotropiques pour un grand nombre de triplets densité-rayon-vecteur de déformation, et détermine par une méthode d'homogénéisation une valeur d'élasticité associée à chaque triplet. Sans perte de généralité, et de manière avantageuse pour les performances, les vecteurs de déformation peuvent être prévus de sorte qu'au moins une des valeurs de chaque vecteur est fixée à 1. Afin de ne pas avoir à explorer toutes les orientations possibles, les mousses produites dans cette phase d'analyse ont une orthotropie alignée avec les axes de chaque cube.

Le modélisateur 10 commence ainsi dans une opération 200 par exécuter une fonction Rand(), et stocke le résultat dans un tableau HDR[]. La fonction Rand() a pour objectif de générer un très grand nombre de triplets densité-rayon-vecteur de déformation, afin de pouvoir offrir une grande variété dans la construction des mousses orthotropiques qui seront produites et analysées par la suite. Cette fonction initialise également un indice i à 1, un indice g à 0, et un tableau TS[] à 0.

Ensuite, le modélisateur 10 exécute une double boucle. Cette double boucle parcourt les triplets du tableau HDR[], et, pour chaque triplet, effectue une boucle dans laquelle un triplet donné est utilisé un grand nombre de fois pour produire une mousse orthotropique d'essai et pour en tirer des valeurs d'élasticité orthotropique correspondantes. Lorsque le vecteur de déformation H contient trois valeurs, les valeurs d'élasticité orthotropiques comprennent trois modules d'élasticité, deux coefficients de Poisson et deux facteurs de cisaillement. Lorsque le vecteur de déformation H contient deux valeurs, les valeurs d'élasticité orthotropiques comprennent deux modules d'élasticité, un coefficient de Poisson et un facteur de cisaillement. Dans ce cas, l'orthotropie ne s'exprime que selon deux dimensions, c'est-à-dire que la mousse sera homogène selon l'une des trois dimensions. Dans l'exemple qui suit, le vecteur de déformation H comprend trois valeurs (hx,hy,hz).

La double boucle commence donc par une opération 210 dans laquelle une fonction Pop() sort un triplet du tableau HDR[]. Ensuite la deuxième boucle commence dans une opération 220 avec l'exécution d'une fonction RandP(). La fonction RandP() reçoit l'indice g comme argument et retourne un point q choisi de manière aléatoire en fonction de g dans un hyper-cube (rayon, densité et vecteur de déformation : 5 dimensions). Cette fonction est utilisée pour générer de la variété dans les mousses orthotropiques de la deuxième boucle. En effet, la fonction RandP() produit des points de départs distincts qui vont générer des graines de branches différentes, ce qui assure la fiabilité de la moyenne réalisée dans la deuxième boucle.

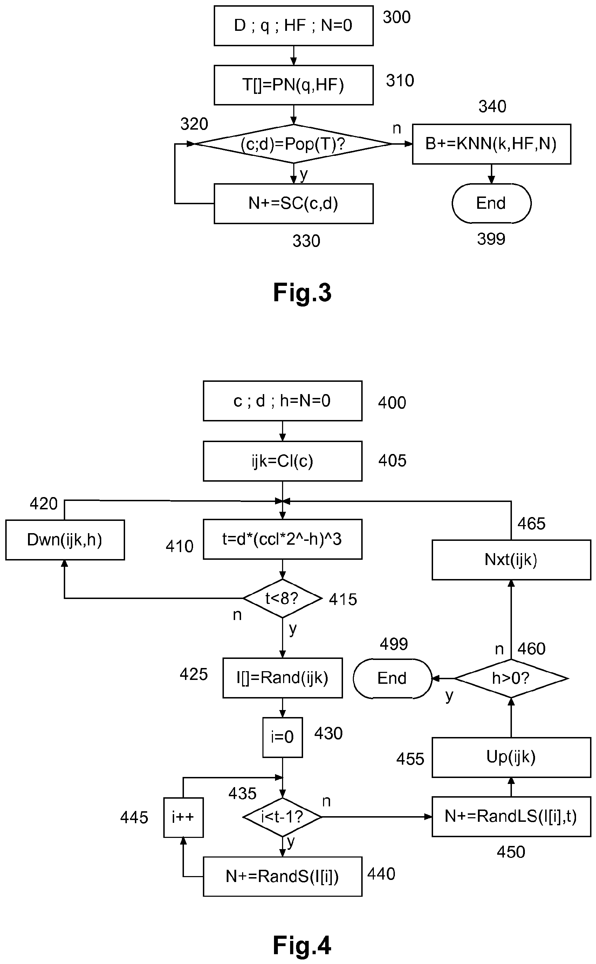

Ensuite, dans une opération 230, une fonction Til() est exécutée qui reçoit comme arguments un pointeur vers une fonction GB(), le point q, le triplet (d,r,H) courant, et l'indice g. La fonction GB() a pour rôle la génération d'un jeu de N de graines de branches qui définiront avec le rayon r la mousse orthotropique de l'instance courante de la deuxième boucle. La figure 3 représente un exemple de mise en œuvre de la fonction GB() et sera décrite plus bas.

La fonction Til() génère une mousse orthotropique en partant de données d'objet décrivant un bloc cubique qui est de dimension suffisante (environ 3cm$^3$ dans l'exemple décrit ici) pour appliquer une méthode d'homogénéisation (voir « Shape optimization by the homogenization method » par Allaire, G. 2012, vol. 146. Springer Science & Business Media), et pour lequel le champ de tenseurs est uniforme, de sorte que l'élasticité est la même dans toute la structure. Ainsi, la méthode d'homogénéisation mesure l'élasticité orthotropique d'un bloc cubique homogène équivalent, pour le triplet (d,r,H) courant Ceci permet d'associer un tenseur d'élasticité orthotropique à chaque vecteur.

Dans l'exemple décrit ici, la fonction Til() génère le cube de mousse d'un seul bloc, en générant toutes les graines de branche en une seule exécution de la fonction GB(). En variante, la fonction Til() peut paralléliser la production des graines de branche en découpant le cube en une pluralité de sous-cubes et en exécutant la fonction GB() sur chaque sous-cube. Cela est rendu possible par le fait que la fonction qui définit les graines de branche à partir du point q de départ est déterministe.

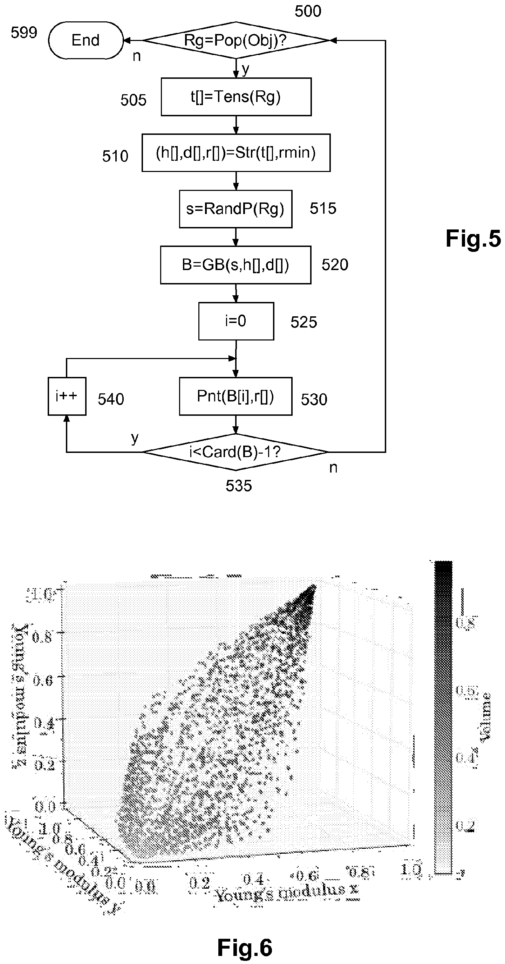

Ensuite, les graines de branches générées par la fonction GB() et le rayon r sont alors utilisés pour déterminer si chaque point du cube est plein ou vide, comme cela sera décrit avec la figure 5. Une fois tous les points p du cube traités, il en résulte une mousse V.

Dans une opération 240, une fonction Hom(), est alors exécutée afin de déterminer la valeur d'élasticité E de la mousse orthotropique V reçue comme argument. L'élasticité de la mousse V est calculée en évaluant le tenseur d'élasticité homogénéisé. La procédure est globalement similaire à celle décrite pour l'isotropie dans « Procédural Voronoi foams for Additive Manufacturing », Martinez et al. 2016, ACM TOG, 35, 4). Une différence importante est que le tenseur à extraire est orthotropique: Une fois le tenseur homogénéisé obtenu, les paramètres du tenseur orthotropique idéal sont extraits par une minimisation de la distance logarithmique Euclidienne entre le tenseur idéal et le tenseur homogénéisé, en contraignant le tenseur orthotropique à rester défini positif. D'autres méthodes sont possibles en variante.

Ce résultat est stocké dans le tableau TS[] à l'indice i. Le tableau TS[] reçoit ainsi la liste des élasticités déterminées pour toutes les mousses associées à un triplet (d,r,H) donné pour un indice i donné d'exécution de la première boucle.

Afin de déterminer si toutes les deuxièmes boucles ont été explorées, l'indice g est comparé à un seuil avgsd dans une opération 250. Si g est inférieur, alors la deuxième boucle est répétée à nouveau pour le même indice i de première boucle, avec l'incrémentation de l'indice g dans l'opération 260.

Sinon, alors la première boucle se termine pour l'indice i, avec l'exécution d'une fonction Avg() dans une opération 270. La fonction Avg() reçoit comme arguments la liste des élasticités TS[i], ainsi que la densité d et le rayon r. La fonction Avg() détermine l'élasticité moyenne des mousses qui ont été réalisées sur la base de toutes les deuxièmes boucles pour l'indice i. Il en résulte un n-uplet associant tenseur orthotropique et le triplet rayon-densité-vecteur de déformation, qui est stocké dans une matrice THDR[]. Afin de déterminer une mesure de précision, il peut être avantageux de calculer également la déviation standard des paramètres des tenseurs d'élasticité pour un indice i donné.

Enfin, l'indice i de première boucle est incrémenté dans une opération 280, l'indice g est réinitialisé à 0 dans une opération 290, et la première boucle reprend avec l'opération 210.

Lorsque l'opération 210 détermine que tous les triplets (d,r,H) du tableau DR[] ont été traités, la fonction se termine dans une opération 299.

La figure 3 va maintenant être décrite afin de mieux comprendre la fonction GB() de l'opération 230.

Comme on le verra avec la figure 5, la mousse orthotropique est construite en reliant entre elles des graines de branche qui ont été générées avec une densité qui dépend des données d'objet 12 La fonction GB() a donc pour rôle, pour un emplacement donné et des données d'objet donné, de générer les graines de branche correspondantes, et de déterminer lesquelles de ces graines de branche sont reliées entre elles.

Comme on le verra plus bas, chaque graine de branche sera reliée à ses plus proches voisines, selon une distance qui tient compte des valeurs des vecteurs de déformation. En effet, la Demanderesse a découvert qu'en choisissant les k voisins les plus proches selon le champ tiré des vecteurs de déformation associés aux tenseurs orthotropiques via les n-uplets, et en fabriquant une mousse à partir des branches reliant ces k plus proches voisins, la mousse résultante a des propriétés orthotropiques correspondant aux tenseurs orthotropiques souhaités.

En variante préférée, la fonction GB() utilise une grille implicite en trois dimensions ayant au moins une graine dans chaque case. Seules les cases proches de la case comprenant l'emplacement donné sont potentiellement pertinentes. Le nombre de cellules à examiner est calculé à partir des valeurs hx, hy, hz du vecteur de déformation associé à une case donnée. Par grille implicite, on entend un pré-découpage cubique en cases de dimension fixe de l'espace, qui dans l'exemple décrit ici présente une dimension comprise entre 2mm et 5mm, et est défini de manière implicite, c'est-à-dire que seul l'indice d'une case est retenu, et que toutes les données y étant relatives sont calculées à la volée. En variante, l'espace pourrait être découpé de manière différente (e.g. grille rhombus, grille en nid d'abeille), et/ou avec des dimensions différentes, et/ou avec une définition explicite. Les graines pourraient aussi être générées sans grille sous-jacente, par tout autre processus générant une distribution aléatoire isotrope de points, comme un algorithme de distribution de points de type tessellation de Voronoi à centroïde, ou bien une distribution à disque de Poisson (par exemple un algorithme de *"dart throwing"*). Dans le cas où une parallélisation est souhaitée, cette distribution doit être de nature déterministe.

La fonction GB() commence dans une opération 300 avec la réception d'un champ de densités D, d'un champ de vecteurs de déformation H et d'un emplacement q comme arguments, ainsi qu'avec l'initialisation à 0 d'un vecteur N. Le champ de densités D et le champ de vecteurs de déformation HF représentent les valeurs de densité d et les vecteurs de déformation H qui sont associés à chaque emplacement de l'espace associé à l'emplacement q qui est traité par la fonction GB().

Dans l'exemple de l'opération 230, le champ de densités D et le champ de vecteurs de déformation HF sont respectivement une valeur de densité d et un vecteur de déformation H choisis pour réaliser le cube de mousse à l'opération 210. Comme on le verra, l'emplacement q joue un rôle important sur l'aléas dans la production des graines de cellules de branche par la fonction GB(), et la variation de g permet donc de générer des mousses orthotropiques très variées pour une densité d fixée.

Après l'initialisation, une fonction PN() est exécutée dans une opération 310. La fonction PN() reçoit q comme argument, et va déterminer toutes les cases qui entourent la case comprenant l'emplacement q et qui sont susceptibles de contenir une graine de branche qui pourrait être un des k voisins les plus proches de la graine de la case contenant q. Pour cela, la fonction PN() commence par agrandir l'espace associé à l'emplacement q sur lequel travaille la fonction GB() en fonction des données de champs de vecteurs de déformation HF.

En effet, le but de la fonction GB() est de déterminer des emplacements de graines de branche pour l'espace couvert par la fonction GB() à partir de l'emplacement q, et de déterminer pour chacune des graines de branches ses voisins les plus proches, selon une distance qui est biaisée par le vecteur de déformation. Cela signifie qu'un plus proche voisin d'une graine donnée pourrait se trouver en dehors de l'espace de travail initial de la fonction GB() et qu'il faut « agrandir » cet espace pour inclure tous les emplacements qui sont susceptibles de contenir une graine de branche qui soit un plus proche voisin. Ainsi, si l'espace sur lequel travaille la fonction GB() est défini par deux coins de cube cmin et cmax, la fonction PN() va retourner un espace [cmin+L ; cmax+L] où L est la valeur maximale à laquelle une graine la plus proche peut se trouver, et est induite par la valeur maximale de toutes les valeurs des vecteurs de déformation H du champ de vecteurs de déformation HF.

Ainsi, la fonction PN() retourne un tableau T[] qui comprend des couples associant chacun un indice de case de l'espace agrandi dans lesquelles des graines de branche doivent être générées, et la densité qui est associée aux emplacements de cette case.

Ensuite, une première boucle est lancée afin de déterminer, pour chaque couple du tableau T[] l'emplacement des graines de branche pour ces cases avec leur densité d. Cette boucle commence dans une opération 320 avec l'extraction d'une case c à visiter dans le tableau T[] et de la densité d correspondante au moyen d'une fonction Pop(), puis une fonction SC() est exécutée dans une opération 330 avec comme arguments la densité d et la case dépilée pour déterminer une ou des graines de branche pour la case c et la densité d. Dans le cas de l'opération 230, la densité d est fixée, et sera donc la même pour toutes les cases. Néanmoins, dans d'autres cas, la fonction PN() peut retourner des cases dont la densité n'est pas la même que celle de la case contenant l'emplacement q.

Ensuite, la première boucle reprend avec l'opération 320, jusqu'à ce que toutes les cases du tableau T[] aient été visitées pour déterminer les graines de branche correspondantes, et que celles-ci aient été entrées dans le vecteur N[].

Une fonction KNN() est alors lancée dans une opération 340, avec comme arguments un nombre de voisins k, le champ de vecteurs de déformation HF et le vecteur N[]. La fonction KNN() parcourt toutes les graines de branche du vecteur N[] et détermine pour chacune d'entre elle les k graines de branche du vecteur N[] qui lui sont les plus proches, selon une distance basée sur la formule suivante :

$$d(r,s) = \frac{\sqrt{(r-s)^T M(r)(r-s)} + \sqrt{(s-r)^T M(s)(s-r)}}{2}$$

où M(r) représente la déformation induite par le vecteur de déformation H du champ de vecteurs de déformation HF à l'emplacement de la graine de branche r, modifié en fonction de l'orientation du repère du tenseur orthotropique auquel il est associé, selon la formule M(r) = R$^T$HR, où R est le repère du tenseur orthotropique auquel est associé le vecteur de déformation H. Dans le cas de l'opération 230, comme les cubes de mousse qui sont générés présentent une orthotropie alignée avec les axes du cube, M est une matrice avec H sur sa diagonale.

De manière avantageuse, pour une graine de branche donnée, le vecteur N[] peut être parcouru pour ne retenir qu'un nombre réduit de voisins potentiels. En effet, en fonction du vecteur de déformation H associé à la graine de branche donné, il est possible de déterminer l'enveloppe minimale dans laquelle se trouveront forcément tous les k voisins potentiels. Cela signifie que, pour cette graine de branche donnée, on peut ignorer toutes les autres graines de branche et qu'il n'est nécessaire de réaliser le calcul de distance ci-dessus et le tri des k distances les plus courtes que sur un nombre restreint de graines de branche.

Les travaux de la Demanderesse ont démontré que, pour des vecteurs de déformation à 3 dimensions, les k voisins sont en pratique contenus dans une sphère centrée sur la graine de branche donnée et dont le rayon vaut 2.

$$c * hx \sqrt[3]{k/(\pi * hx * hy * hz)}$$ avec c la dimension d'une case et h la plus grande valeur entre hx, hy et hz. Pour des vecteurs de déformation à 2 dimensions, les k voisins sont contenus dans un cercle centré sur la graine de branche donnée et dont le rayon vaut 2. $$c * hx \sqrt{k/(\pi * hx * hy)},$$ où c est la taille de la case associée à la graine de branche donnée. Une borne plus resserrée pourrait être déterminée.

Sur la base de ces distances, la fonction KNN() retient, pour chaque graine de branche, les k graines qui donnent la distance la plus faible. Les expériences de la Demanderesse ont démontré qu'un nombre de voisins k supérieur ou égal à 2 suffit à obtenir des résultats connectés (c'est-à-dire des mousses monobloc) dans la plupart des cas, et qu'un excellent compromis anisométrie / connectivité / temps de calcul est obtenu avec k égal à 6. Dans l'exemple décrit ici, le nombre k est gardé constant pendant l'exécution de la fonction GB(). En variante, la valeur de k pourrait varier pendant l'exécution de la fonction GB().

La fonction KNN() retourne une liste B des graines qui doivent être reliées entre elles. Cette liste peut être sous la forme de couples, ou de n-uplets dans lesquelles le premier élément désigne une graine de branche centrale, et les autres membres du n-uplets toutes les graines de branches auxquelles la graine de branche centrale doit être reliée. Dans ce dernier cas, cela revient à remplacer dans le vecteur N[] chaque graine de branche par le n-uplet dont le premier élément est la graine de branche correspondante.

Enfin, la fonction GB() se termine avec l'opération 399.

La figure 4 représente un exemple de réalisation de la fonction SC(). Cette fonction a pour rôle, à partir d'une case c et d'une densité reçues en arguments, de générer les graines de branches correspondant à la densité recherchée. Pour cela, la case c va être divisée de manière répétée en sous-cases, jusqu'à ce que la taille des sous-cases soit telle que chaque sous-case contienne environ une graine. Il est important de noter que différents appels de la fonction SC(d;c) vont toujours générer exactement le même ensemble de graines pour une même case c. Dit autrement, la fonction SC() est déterministe pour un même emplacement q originel.

Pour cela, dans une opération 400, la case c et la densité d sont reçues comme argument, et un indice de profondeur h ainsi qu'un vecteur N recevant les graines de branches sont initialisés à 0.

Ensuite, dans une opération 405, une fonction CI() est exécutée pour déterminer les coordonnées de la case c. Cette détermination est importante pour la parallélisation de la fonction SC() comme on le verra plus bas.

La case c est alors divisée en sous-cases dans une boucle impliquant des opérations 410, 415 et 420. Dans l'opération 410, un nombre de graines théorique t est calculé en multipliant la densité d par une constante ccl correspondant à la taille des cases au plus haut niveau, laquelle constante est multipliée par deux à la puissance moins h, ce produit étant élevé au cube. En effet, dans l'exemple décrit ici, comme l'espace est découpé de manière cubique, chaque profondeur supplémentaire (quand h croit) divise le volume de la case par huit. Dans l'opération 415, t est comparé à 8. En effet, si t est inférieur à 8, alors il n'est plus nécessaire de découper la case en sous-cases, puisque chaque sous-case aura au maximum une graine de branche. Sinon, dans une opération 420, une fonction Dwn() augmente les dimensions ijk afin de sous-diviser la case en huit sous-cases, puis l'opération 410 est répétée.

Dans l'exemple décrit ici, les cases sont cubiques et sont découpées de manière identique en sous-cases de volume identique, et toutes les cases de niveau le plus élevé ont un volume égal à celui de la case de niveau le plus élevé contenant l'emplacement q. En variante, les volumes des cases pourraient varier, les formes des cases et des sous-cases également, et le nombre de graines dans les sous-cases serait alors évalué en conséquence, de sorte que la somme du nombre de graines générées dans les sous-cases corresponde au nombre de graines calculé pour leur case parente, comme les sous-cases forment une partition du volume de cette dernière.

Lorsque la profondeur la plus basse utile pour la densité recherchée a été atteinte, une fonction Rand(ijk) est exécutée dans une opération 425. Cette fonction rentre dans un vecteur I[] huit indices dans un ordre pseudo-aléatoire, chaque indice désignant une sous-case. La fonction étant pseudo-aléatoire, le même tableau I[] est produit pour une même valeur de ijk.

Ensuite, un indice i est initialisé à 0 dans une opération 430. L'indice i est utilisé pour parcourir les sous-cases du vecteur I[] et leur attribuer une graine de branche si nécessaire.

Une boucle est ainsi exécutée, dans laquelle une opération 435 détermine si suffisamment de graines ont été générées. En effet, t sera généralement une valeur non entière. L'indice i est donc comparé à t-1. Si i est inférieur à t-1, alors il faut encore produire une graine de branche dans la case désignée par I[i].

Pour cela, une fonction RandS() est exécutée dans une opération 440. Cette fonction reçoit comme argument I[i] et détermine de manière pseudo-aléatoire un emplacement dans la case désignée par l'indice I[i], et le place dans le vecteur N de sorte qu'il occupe l'indice 0 s'il est plus proche de l'emplacement q que la graine de branche occupant l'indice 0.

L'aléa de cette fonction dépend au moins en partie de l'indice de la sous-case, ce qui signifie qu'à chaque fois que la fonction est exécutée avec cet indice, c'est la même graine de branche qui est générée. Et lorsque l'indice change, une autre graine aléatoire est générée, etc. Ainsi, la fonction RandP(g) de l'opération 220 fait varier les motifs de mousse orthotropiques produits, puisqu'elle fait varier l'indice de la case pour laquelle les graines sont cherchées en modifiant les points q.

La graine de branche correspondante est stockée dans le vecteur N, puis l'indice i est incrémenté dans une opération 445, puis le test de l'opération 435 est répété. Lorsque ce test est négatif, il faut générer une graine de branche dans la prochaine sous-case, selon une probabilité correspondant à la partie décimale de t.

Pour cela, une fonction RandLS() est exécutée dans une opération 450 et reçoit comme argument I[i] et t. La fonction RandLS() est très similaire à la fonction RandS(), sauf qu'elle ne crée dans la sous-case restante (c'est-à-dire celles désignée par l'indice I[i]) qu'avec une probabilité égale à la partie décimale de t (c'est-à-dire t moins partie entière de t). Si une graine est ainsi générée, elle est également reçue dans le vecteur N.

Ensuite, dans une opération 455, une fonction Up() qui reçoit ijk comme argument est exécutée. Cette fonction détermine si la case ijk actuelle est la dernière case fille de la case parente de niveau supérieur, c'est-à-dire dans l'exemple ici décrit si ijk modulo (2,2,2) vaut (1,1,1). Si c'est le cas, alors les huit sous-cases de la case parente de niveau supérieur ont été traitées, et la fonction décrémente l'indice de profondeur h. La valeur ijk est alors mise à jour en gardant la partie entière d'une division par (2,2,2), obtenant ainsi l'indice de la case parente de niveau supérieur. Par exemple, si la profondeur h était égale à 3 et l'indice ijk égal à (3,7,7), le nouvel indice h est égal à 2, et l'indice ijk égal à (1,3,3), qui correspond à la case parente. Ce nouvel indice est lui-même testé pour déterminer si la case ijk actuelle est la dernière du niveau donné. L'opération est répétée jusqu'à déterminer une case ijk qui n'est pas la dernière case fille de son parent de niveau supérieur, ou qui est au niveau le plus élevé. Ainsi, lorsque la dernière sous-case du niveau le plus profond est traitée, la fonction Up() remonte jusqu'au niveau 0.

Ensuite, un test dans une opération 460 détermine si toutes les cases ont été traitées (c'est-à-dire si h a été décrémenté jusqu'à 0). S'il reste des sous-cases à parcourir, une fonction Nxt() qui reçoit ijk comme argument est exécutée dans une opération 465, et sinon la fonction SC() s'arrête dans une opération 499. La fonction Nxt() est agencée pour organiser le parcours des sous-cases ayant une même case parente. En effet, comme à chaque niveau une case donnée se sous-divise en huit sous-cases, la case ijk de niveau h est une parmi huit sous-cases de sa case parente. La fonction Nxt() ajuste ijk pour parcourir les sous-cases d'une même case parente selon un ordre garantissant que toutes les cases sont explorées, la dernière sous-case visitée ayant un indice ijk modulo (2,2,2) égal a (1,1,1). La boucle reprend alors avec l'opération 410, pour redescendre aussi profond que nécessaire dans la nouvelle case, etc.

Cet agencement est particulièrement avantageux, car il permet de paralléliser massivement les opérations de la fonction SC(), par exemple pour les exécuter sur un processeur graphique. En variante, la fonction SC() pourrait être programmée de manière récursive, ce qui est plus simple en termes de programmation, mais pose des problèmes pour un traitement parallélisé sur un GPU ou une architecture sans pile de données à l'exécution.

La figure 5 représente un exemple d'une fonction mise en œuvre par le constructeur 4 pour fabriquer l'objet 14 à partir des données d'objet 12.

La fabrication est une boucle dans laquelle les données d'objet 12, qui décrivent la forme de l'objet en trois dimensions, ainsi que l'orthotropie recherchée pour chaque portion, sont progressivement dépilées pour construire l'objet 14.

Une première opération est exécutée pour récupérer toutes les informations relatives à une région donnée. En effet, comme la fonction SC() est déterministe, les graines de branche seront toujours les mêmes pour une même région de l'espace.

Par conséquent, il est possible de découper l'objet en plusieurs régions, par exemple des cubes, et de calculer les branches pour chaque cube, en parallèle. Une approche procédurale serait également possible, mais aurait un coup de calcul très supérieur car le calcul des branches nécessite de déterminer les k voisins les plus proches pour chaque graine de branche.

Ainsi dans une opération 500, les données d'objet 12 sont dépilées par une fonction Pop(), et stockées dans une variable Rg. Cette variable reçoit toutes les données de tenseurs orthotropiques d'un bloc courant à imprimer et les données d'orientation (angles) de celles-ci, définissant ainsi un champ de tenseurs variant dans l'espace.

Ensuite, dans une opération 505, une fonction Tens() extrait toutes les données de tenseurs orthotropiques et les données d'orientation correspondant aux champ de tenseurs et les range dans un vecteur t[]. Cette fonction peut être une simple copie ou comprendre une opération de normalisation ou d'homogénéisation pour tenir compte d'un contexte lié à un objet particulier.

Le vecteur t[] est exploité dans une opération 510 par une fonction Str() qui le reçoit comme argument, ainsi qu'un rayon rmin qui représente le rayon minimal d'impression de l'imprimante 6.

La fonction Str() est importante car son résultat est un champ de vecteurs h[], d[] et r[] qui déterminent le nombre de graines de branche et l'épaisseur des branches correspondantes dans la mousse orthotropique qui sera imprimée.

Pour cela, la fonction Str() accède à la mémoire 8 pour déterminer, pour chaque élément du vecteur t[] un triplet associant un rayon r, une densité d et des valeurs de vecteur de déformation hx, hy, hz. Comme on l'a vu, ce triplet a été calculé précédemment par le modélisateur 10.

Dans l'exemple décrit ici, les triplets ont été déterminés en appliquant la théorie de l'homogénéisation à un motif de mousse orthotropique répliqué. La théorie de l'homogénéisation a été validée pour des objets réguliers, c'est-à-dire composés uniquement d'un seul motif répété. Cependant, le but recherché est précisément une hétérogénéité d'élasticité, et donc la mousse orthotropique formant l'objet 14 ne sera par nature pas d'un seul motif répété.

Les travaux de la Demanderesse ont néanmoins montré que l'hypothèse d'homogénéité restait valable dans le cas des mousses orthotropiques, avec une correspondance d'autant meilleure que la densité est élevée, car la mousse à une échelle petite par rapport au volume rempli. Pour cette raison, la fonction Str() est prévue pour choisir en priorité un triplet dans lequel le rayon r vaut rmin, afin de maximiser la densité d. La figure 6 représente un exemple de diagramme tridimensionnel reliant tous les triplets pour un type de matériau additif choisi, comme une résine photosensible commercialisée sous le nom « B9R-1-Cherry » par la société B9Creators (marque déposée). Lorsqu'une valeur n'est pas explicitement présente, elle peut être interpolée à partir des valeurs présentes les plus proches. Les données représentées sur la figure 6 peuvent aussi être approximées par un polynôme, afin d'impliciter encore plus les données. Lorsque que, pour une élasticité donnée, le rayon rmin nécessiterait une densité trop importante, c'est la prochaine épaisseur réalisable après rmin qui est retenue, etc.

Ensuite, les branches de la mousse orthotropique vont être générées afin de définir pour chaque point de la région Rg si l'imprimante 6 doit ajouter de la matière, ou pas.

Dans une opération 515, un point s est initialisé de manière aléatoire dans Rg. Ensuite, dans une opération 520, les graines de branches du bloc courant et les branches correspondantes sont calculées au moyen de la fonction GB(), en tenant compte des données d'orientation de l'opération 500.

Une boucle est alors lancée qui parcourt toutes les branches, et définit comme plein les points à l'intérieur d'un espace situé autour de chaque branche ayant l'épaisseur du rayon r associé à la région de cette branche.

Pour cela, dans une opération 525, un indice i est initialisé à 0 pour parcourir le vecteur B issu de l'opération 520, puis dans une opération 530, une fonction Pnt() détermine les emplacements qui doivent être imprimés autour de la branche B[i], et commande l'imprimante 6 en conséquence.

Ensuite, un test vérifie dans une opération 535 si toutes les branches ont été parcourues. Si ce n'est pas le cas, alors l'indice i est incrémenté dans une opération 540 et la boucle reprend avec la branche suivante. Si c'est le cas, alors le calcul est répété pour la région suivante avec l'opération 500.

Une fois que toutes les couches Rg ont été traitées, l'objet 14 a été imprimé et la fonction s'arrête avec une opération 599.

Comme on l'a vu plus haut, les régions peuvent être traitées en parallèle, et la fonction de la figure 5 pourra être modifiée en conséquence. De plus, la fonction PN() de la fonction GB() est susceptible d'aller sélectionner des graines en dehors de la région Rg traitée. Grâce au caractère déterministe de la sélection des graines, cela ne pose néanmoins pas de problème de discontinuité aux frontières des régions, le contenu restant strictement identique de part et d'autre. De plus, lorsqu'une branche aura été déterminée entre deux graines appartenant à une première région Rgl et une deuxième région Rg2, et que la région Rgl fait l'objet d'un calcul avant la région Rg2, il ne sera plus nécessaire de reprendre ce calcul pour cette branche pour la région Rg2.

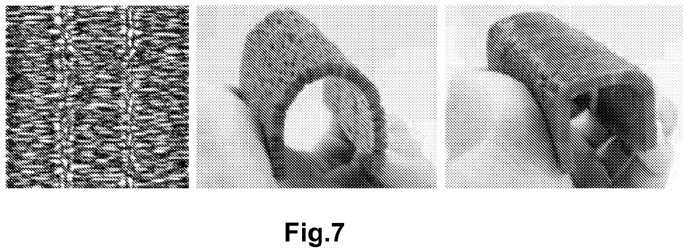

La figure 7 montre un exemple d'application de l'invention dans le plan (2D) dans lequel l'objet produit se déforme en U lorsqu'il est plié selon un axe, et en C lorsqu'il est plié selon un autre axe.

Les fonctions GB() et SC() sont donc particulièrement avantageuses car elles permettent de réduire fortement la quantité d'informations à stocker d'un bout à l'autre de la chaîne. En effet, les mousses orthotropiques sont intégralement définies par le champ de tenseurs et leurs orientations.

Ainsi, de la production des triplets à leur consommation avec un champ de tenseurs pour fabriquer les objets, un nombre réduit de paramètres suffisent à définir les mousses orthotropiques de l'invention. Cela permet d'économiser une quantité de données précédemment ingérable dans l'état de l'art, avec un coût de calcul raisonnable. De plus, il apparaît que le constructeur 4 comme le modélisateur 10 sont chacun un générateur de graines de branches utilisées pour définir si des emplacements sont pleins ou vides dans un objet final, qu'il serve à une qualification d'élasticité ou dans un objet à fabriquer. Enfin, la méthode proposée permet de générer une élasticité orthotropique librement orientable dans une pièce ce qui n'est possible avec aucune autre méthode de l'état de l'art.

La Demanderesse a étudié l'application de l'invention aux diverses méthodes de fabrication additive et a validé les éléments suivants :

- Pour une impression à filament, l'impression est possible avec une variation de l'élasticité selon deux axes seulement, l'élasticité étant homogène selon la troisième direction,
- Pour une impression à poudre, l'épaisseur obtenue pour les branches peut descendre à $100\mu m$, et
- Pour une impression à poudre, l'épaisseur obtenue pour les branches peut descendre à $250\mu m$.

De nombreuses variantes peuvent être envisagées. En effet, concernant les emplacements correspondant à une surface de l'objet, le traitement peut être complété pour apporter une « peau » ou du moins offrir une surface régulière (nonobstant les trous). Pour cela, il est possible de rajouter une couche supplémentaire de matière le long de la surface de l'objet, d'épaisseur choisie, donnant ainsi un aspect lisse à celui-ci. Optionnellement cette couche peut être partiellement ajourée.

De même, lorsqu'il est détecté qu'un emplacement q est proche de deux branches sans être suffisamment proche compte tenu de leur rayon, il peut néanmoins être prévu d'imprimer l'emplacement correspondant, afin d'améliorer la tenue aux embranchements des branches entre elles. La création des triplets peut être modifiée pour tenir compte d'analyses de conformité de l'élasticité. Enfin, pour des raisons esthétiques il est possible d'utiliser une densité plus faible et un rayon plus fort pour une élasticité donnée, ou tout autre choix pour faire correspondre un rayon et une densité à l'élasticité choisie.

Un autre avantage majeur de l'invention est qu'elle permet de réaliser des objets dont la rigidité est connue avec un poids très inférieur aux techniques classiques, car l'orthotropie permet de mieux s'adapter à des contraintes inhomogènes dans les pièces.

Bien que l'exemple décrit plus haut soit en référence à une fabrication additive, les mousses orthotropiques de l'invention pourraient être réalisées différemment, par exemple par moulage ou par extrusion.

**Revendications**

1. Dispositif de traitement de données pour fabrication de mousse orthotropique, comprenant une mémoire (8) agencée pour recevoir des données d'emplacement désignant un emplacement et un élément de volume contenant cet emplacement, et un générateur (4) agencé pour déterminer des données de fabrication additive indiquant si un emplacement associé à des données d'emplacement est vide ou plein, **caractérisé en ce que** :

   - la mémoire (8) est agencée pour recevoir des données de densité, des données de déformation et des données de rayon, et **en ce que**
   - le générateur (4, 10) est agencé pour calculer, pour un emplacement donné désigné par des données d'emplacement, des données de graines de branche désignant des emplacements de graines de branches d'un jeu de graines de branches associé à l'emplacement donné,
   - le générateur est agencé pour déterminer lesdits emplacements de graines de branche dans une pluralité d'éléments de volumes comprenant l'élément de volume contenant l'emplacement donné d'une part et des éléments de volumes sélectionnés dans un voisinage de l'élément de volume contenant l'emplacement donné d'autre part, chaque élément de volume recevant un nombre de graines de branche tiré de données de densité associées à cet élément de volume la mousse orthotropique étant construite en reliant entre elles ces graines de branche,
   - le générateur (4, 10) est en outre agencé pour calculer une mesure entre une première graine de branche et une deuxième graine de branche à partir de la distance entre l'emplacement de la première graine de branche d'une part et la deuxième graine de branche d'autre part, en pondérant cette distance en fonction de données de déformation associées à la première graine de branche et à la deuxième graine de branche,
   - le générateur (4, 10) est en outre agencé pour sélectionner au moins deux graines de branches pour chaque graine de branche, de sorte que ces au moins deux graines de branches sont les voisins les plus proches selon la mesure calculée par le générateur (4, 10), et
   - le générateur (4, 10) est en outre agencé pour définir des données de fabrication indiquant qu'un emplacement est plein lorsque la distance entre ledit emplacement et sa projection sur une des branches reliant chaque graine de branche à ses voisins les plus proches est inférieure à une distance tirée des données de rayon.

2. Dispositif selon la revendication 1, dans lequel le générateur (4, 10) est outre agencé pour calculer la mesure entre une première graine de branche et une deuxième graine de branche en la pondérant en fonction d'un référentiel associé aux données de déformation.

3. Dispositif selon la revendication 1 ou 2, dans lequel le générateur (4, 10) est agencé pour sélectionner les voisins les plus proches d'une graine de branche donnée parmi un sous-ensemble de graines de branches qui exclut les graines de branche dont les emplacements sont situés à une distance de l'emplacement de la graine de branche donnée supérieure à un seuil tiré des données de déformation et du nombre de voisins les plus proches recherchés.

4. Dispositif selon l'une des revendications précédentes, dans lequel le générateur (4, 10) est agencé pour allouer les graines de branche de manière déterministe au sein de chaque élément de volume

5. Dispositif selon l'une des revendications précédentes, dans lequel le générateur (4, 10) est agencé pour déterminer lesdits emplacements de graines de branche en divisant chaque élément de volume de la pluralité d'éléments de volume en un ou plusieurs sous-éléments de volume dont le nombre est calculé à partir des données de densité et du volume de chaque élément de volume, en déterminant de manière pseudo-aléatoire en fonction des données d'emplacement et des données de densité des sous-éléments de volume recevant une graine de branche, et en déterminant de façon pseudo-aléatoire dans chaque sous-élément de volume recevant une graine de branche des données de graine de branche désignant un emplacement dans ce sous-élément de volume.

6. Dispositif selon l'une des revendications 1 à 5, dans lequel le générateur (4, 10) est un modélisateur (10) agencé pour recevoir un triplet associant des données de densité, des données de déformation et des données de rayon, pour déterminer un jeu de données de fabrication additive pour un objet de forme sensiblement cubique à partir de ce couple, et pour appliquer une méthode d'homogénéisation pour en tirer une donnée de tenseur.

7. Dispositif selon la revendication 6, dans lequel le modélisateur (10) est agencé, pour un triplet donné, pour déterminer plusieurs jeux de données de fabrication additive en faisant varier les déterminations pseudo-aléatoires, et pour réaliser une moyenne des données de tenseur pour le triplet donné.

**8.** Dispositif selon l'une des revendications 1 à 5, dans lequel le générateur (4,10) est un constructeur (4) agencé pour recevoir des données d'objet (12) définissant la forme d'un objet à produire par fabrication additive et comprenant des données de tenseur associées à des emplacements désignés par les données d'objet, et, pour certains au moins des emplacements des données d'objets, pour déterminer des données de déformation, des données de référentiel, des données de rayon et des données de densité à partir des données de tenseur associées, et pour déterminer des données de fabrication additive correspondantes.

**9.** Procédé de fabrication d'une mousse orthotropique, **caractérisé en ce qu'**il comprend les opérations suivantes :

- recevoir des données d'objet associant des données d'emplacement et des données de tenseur, les données de tenseur étant associées à des données de densité, des données de rayon et des données de déformation, et les données d'emplacement désignant un emplacement et un élément de volume contenant cet emplacement,
- déterminer des emplacements de graines de branche dans une pluralité d'éléments de volume, le nombre de graines de branche dans un élément de volume donné étant déterminé à partir des données de densité associées aux emplacements de l'élément de volume donné la mousse orthotropique étant construite en reliant entre elles ces graines de branche,
- pour chaque graine de branche, calculer une pluralité de mesures entre cette graine de branche en tant que première graine de branche d'une part et une deuxième graine de branche d'autre part, la deuxième graine de branche étant choisie pour chaque mesure parmi les autres graines de branche, la mesure étant calculée à partir de la distance entre l'emplacement de la première graine de branche d'une part et la deuxième graine de branche d'autre part, en pondérant cette distance en fonction de données de déformation associées à la première graine de branche et à la deuxième graine de branche,
- sélectionner au moins deux graines de branches pour chaque graine de branche, de sorte que ces au moins deux graines de branches sont les voisins les plus proches dans la pluralité de mesures calculées pour chaque graine, et
- définir des données de fabrication indiquant qu'un emplacement donné est plein lorsque la distance entre ledit emplacement donné et sa projection sur une des branches reliant chaque graine à ses voisins les plus proches est inférieure à une distance tirée de données de rayon, et
- fabriquer une mousse suivant les emplacements pleins définis.

**10.** Procédé selon la revendication 9, dans lequel la mesure entre une première graine de branche et une deuxième graine de branche est pondérée en fonction d'un référentiel associé aux données de déformation.

**11.** Procédé selon la revendication 9 ou 10, dans lequel pour sélectionner les voisins les plus proches d'une graine de branche donnée, la pluralité de mesures est calculée avec un sous-ensemble de graines de branches qui exclut les graines de branche dont les emplacements sont situés à une distance de l'emplacement de la graine de branche donnée supérieure à un seuil tiré des données de déformation et du nombre de voisins les plus proches recherchés.

**12.** Procédé selon l'une des revendications 9 à 11, dans lequel lesdits emplacements de graines de branche sont déterminés de manière déterministe.

**13.** Procédé selon l'une des revendications 9 à 12, dans lequel lesdits emplacements de graines de branche sont déterminés en divisant chaque élément de volume de la pluralité d'éléments de volume en un ou plusieurs sous-éléments de volume dont le nombre est calculé à partir des données de densité et du volume de chaque élément de volume, en déterminant de manière pseudo-aléatoire en fonction des données d'emplacement et des données de densité des sous-éléments de volume recevant une graine de branche, et en déterminant de façon pseudo-aléatoire dans chaque sous-élément de volume recevant une graine de branche des données de graine de branche désignant un emplacement dans ce sous-élément de volume.

**14.** Procédé selon l'une des revendications 9 à 13, dans lequel l'opération de fabrication de mousse est réalisée par fabrication additive.

**Patentansprüche**

**1.** Datenverarbeitungsvorrichtung für die Fertigung von orthotropem Schaumstoff, die einen Speicher (8) umfasst, der so eingerichtet ist, dass er Positionsdaten empfängt, die eine Position und ein Volumenelement, das diese Position enthält, bezeichnen, und einen Generator (4), der so eingerichtet ist, dass er Daten für die additive Fertigung bestimmt, die angeben, ob eine Position, die mit Positionsdaten verknüpft ist, leer oder voll ist, **dadurch gekennzeichnet, dass**:

- der Speicher (8) so eingerichtet ist, dass er Dichtedaten, Verformungsdaten und Radiusdaten empfängt, und dadurch, dass
- der Generator (4, 10) so eingerichtet ist, dass er für eine von Positionsdaten bezeichnete, gegebene Position Zweigknotendaten berechnet, die Positionen von Zweigknoten eines Satzes von Zweigknoten, der mit der gegebenen Position verknüpft ist, bezeichnen,
- der Generator so eingerichtet ist, dass er die Positionen von Zweigknoten in einer Vielzahl von Volumenelementen bestimmt, die einerseits das Volumenelement, das die gegebenen Position enthält, und andererseits ausgewählte Volumenelemente in einer Nachbarschaft des Volumenelements, das die gegebene Position enthält, umfasst, wobei jedes Volumenelement eine Anzahl von Zweigknoten aufnimmt, die aus mit diesem Volumenelement verknüpften Dichtedaten abgeleitet ist, wobei der orthotrope Schaumstoff konstruiert wird, indem diese Zweigknoten miteinander verbunden werden,
- der Generator (4, 10) weiter so eingerichtet ist, dass er ein Maß zwischen einem ersten Zweigknoten und einem zweiten Zweigknoten auf Grundlage der Entfernung zwischen der Position einerseits des ersten Zweigknotens und andererseits des zweiten Zweigknotens berechnet, indem er diese Entfernung in Abhängigkeit von Verformungsdaten, die mit dem ersten Zweigknoten und dem zweiten Zweigknoten verknüpft sind, gewichtet,
- der Generator (4, 10) weiter so eingerichtet ist, dass er für jeden Zweigknoten mindestens zwei Zweigknoten so auswählt, dass diese mindestens zwei Zweigknoten gemäß dem vom Generator (4, 10) berechneten Maß die nächsten Nachbarn sind, und
- der Generator (4, 10) weiter so eingerichtet ist, dass er Fertigungsdaten definiert, die angeben, dass eine Position voll ist, wenn die Entfernung zwischen der Position und ihrer Projektion auf einen der Zweige, die jeden Zweigknoten mit seinen nächsten Nachbarn verbinden, kleiner ist als eine aus den Radiusdaten abgeleitete Entfernung.

2. Vorrichtung nach Anspruch 1, wobei der Generator (4, 10) weiter so eingerichtet ist, dass er das Maß zwischen einem ersten Zweigknoten und einem zweiten Zweigknoten berechnet, indem er es in Abhängigkeit von einem Bezugssystem, das mit den Verformungsdaten verknüpft ist, gewichtet.

3. Vorrichtung nach Anspruch 1 oder 2, wobei der Generator (4, 10) so eingerichtet ist, dass er die nächsten Nachbarn eines gegebenen Zweigknotens aus einer Teilmenge von Zweigknoten auswählt, die die Zweigknoten ausschließt, deren Positionen in einer Entfernung von der Position des gegebenen Zweigknotens liegen, die größer ist als eine aus den Verformungsdaten und der Anzahl von gesuchten nächsten Nachbarn abgeleitete Schwelle.

4. Vorrichtung nach einem der vorstehenden Ansprüche, wobei der Generator (4, 10) so eingerichtet ist, dass er die Zweigknoten in deterministischer Weise innerhalb jedes Volumenelements zuweist.

5. Vorrichtung nach einem der vorstehenden Ansprüche, wobei der Generator (4, 10) so eingerichtet ist, dass er die Positionen von Zweigknoten bestimmt, indem er jedes Volumenelement aus der Vielzahl von Volumenelementen in ein oder mehrere Volumen-Teilelemente unterteilt, deren Anzahl auf Grundlage der Dichtedaten und des Volumens jedes Volumenelements berechnet wird, indem er in pseudozufälliger Weise in Abhängigkeit von den Positionsdaten und den Dichtedaten Volumen-Teilelemente bestimmt, die einen Zweigknoten aufnehmen, und indem er in pseudozufälliger Art in jedem Volumen-Teilelement, das einen Zweigknoten aufnimmt, Zweigknotendaten bestimmt, die eine Position in diesem Volumen-Teilelement bezeichnen.

6. Vorrichtung nach einem der Ansprüche 1 bis 5, wobei es sich beim Generator (4, 10) um einen Modellierer (10) handelt, der so eingerichtet ist, dass er ein Triplet empfängt, das Dichtedaten, Verformungsdaten und Radiusdaten verknüpft, auf Grundlage dieses Paares einen Datensatz für die additive Fertigung für ein Objekt von im Wesentlichen kubischer Form bestimmt, und ein Homogenisierungsverfahren anwendet, um daraus ein Tensordatum abzuleiten.

7. Vorrichtung nach Anspruch 6, wobei der Modellierer (10) so eingerichtet ist, dass er für ein gegebenes Triplet mehrere Datensätze für die additive Fertigung bestimmt, indem er die pseudozufälligen Bestimmungen variiert, und für das gegebene Triplet ein Mittel der Tensordaten bildet.

8. Vorrichtung nach einem der Ansprüche 1 bis 5, wobei es sich beim Generator (4, 10) um einen Konstruktor (4) handelt, der so eingerichtet ist, dass er Objektdaten (12) empfängt, die die Form eines Objekts, das durch additive Fertigung produziert werden soll, definieren und Tensordaten umfassen, die mit von den Objektdaten bezeichneten Positionen verknüpft sind, und auf Grundlage der verknüpften Tensordaten für mindestens einige der Positionen der Objektdaten Verformungsdaten, Bezugssystemdaten, Radiusdaten und Dichtedaten bestimmt und entsprechende Daten für die additive Fertigung bestimmt.

9. Verfahren für die Fertigung eines orthotropen Schaumstoffs, **dadurch gekennzeichnet, dass** es die folgenden Vorgänge umfasst:

- Empfangen von Objektdaten, die Positionsdaten und Tensordaten verknüpfen, wobei die Tensordaten mit Dichtedaten, Radiusdaten und Verformungsdaten verknüpft sind, und wobei die Positionsdaten eine Position und ein Volumenelement bezeichnen, das diese Position enthält,
- Bestimmen von Positionen von Zweigknoten in einer Vielzahl von Volumenelementen, wobei die Anzahl von Zweigknoten in einem gegebenen Volumenelement auf Grundlage der Dichtedaten bestimmt wird, die mit den Positionen des gegebenen Volumenelements verknüpft sind, wobei der orthotrope Schaumstoff konstruiert wird, indem diese Zweigknoten miteinander verbunden werden,
- Berechnen, für jeden Zweigknoten, einer Vielzahl von Maßen zwischen einerseits diesem Zweigknoten als erstem Zweigknoten und andererseits einem zweiten Zweigknoten, wobei der zweite Zweigknoten für jedes Maß aus den anderen Zweigknoten gewählt wird, wobei das Maß auf Grundlage der Entfernung zwischen der Position einerseits des ersten Zweigknotens und andererseits des zweiten Zweigknotens berechnet wird, indem diese Entfernung in Abhängigkeit von Verformungsdaten, die mit dem ersten Zweigknoten und dem zweiten Zweigknoten verknüpft sind, gewichtet wird,
- Auswählen von mindestens zwei Zweigknoten für jeden Zweigknoten so, dass diese mindestens zwei Zweigknoten in der Vielzahl von Maßen, die für jeden Knoten berechnet wurden, die nächsten Nachbarn sind, und
- Definieren von Fertigungsdaten, die angeben, dass eine gegebene Position voll ist, wenn die Entfernung zwischen der gegebenen Position und ihrer Projektion auf einen der Zweige, die jeden Knoten mit seinen nächsten Nachbarn verbinden, kleiner ist als eine aus Radiusdaten abgeleitete Entfernung, und
- Fertigen eines Schaumstoffs gemäß den definierten vollen Positionen.

10. Verfahren nach Anspruch 9, wobei das Maß zwischen einem ersten Zweigknoten und einem zweiten Zweigknoten in Abhängigkeit von einem Bezugssystem, das mit den Verformungsdaten verknüpft ist, gewichtet wird.

11. Verfahren nach Anspruch 9 oder 10, wobei, um die nächsten Nachbarn eines gegebenen Zweigknotens auszuwählen, die Vielzahl von Maßen mit einer Teilmenge von Zweigknoten berechnet wird, die die Zweigknoten ausschließt, deren Positionen in einer Entfernung von der Position des gegebenen Zweigknotens liegen, die größer ist als eine aus den Verformungsdaten und der Anzahl von gesuchten nächsten Nachbarn abgeleitete Schwelle.

12. Verfahren nach einem der Ansprüche 9 bis 11, wobei die Positionen von Zweigknoten in deterministischer Weise bestimmt werden.

13. Verfahren nach einem der Ansprüche 9 bis 12, wobei die Positionen von Zweigknoten bestimmt werden, indem jedes Volumenelement aus der Vielzahl von Volumenelementen in ein oder mehrere Volumen-Teilelemente unterteilt wird, deren Anzahl auf Grundlage der Dichtedaten und des Volumens jedes Volumenelements berechnet wird, indem Volumen-Teilelemente, die einen Zweigknoten aufnehmen, in pseudozufälliger Weise in Abhängigkeit von den Positionsdaten und den Dichtedaten bestimmt werden, und indem in jedem Volumen-Teilelement, das einen Zweigknoten aufnimmt, Zweigknotendaten, die eine Position in diesem Volumen-Teilelement bezeichnen, in pseudozufälliger Art bestimmt werden.

14. Verfahren nach einem der Ansprüche 9 bis 13, wobei der Vorgang der Schaumstofffertigung durch additive Fertigung ausgeführt wird.

**Claims**

1. A data processing device for manufacturing orthotropic foam, comprising a memory (8) arranged to receive location data designating a location and a volume element containing this location, and a generator (4) arranged to determine additive manufacturing data indicating if a location associated with the location data is empty or full, **characterized in that**:

- the memory (8) is arranged to receive density data, deformation data and radius data, and **in that**
- the generator (4, 10) is arranged to calculate, for a given location designated by location data, branch grain data designating locations of branch grains of a set of branch grains associated with the given location,
- the generator is arranged to determine said branch grain locations in a plurality of volume elements comprising the volume element containing the given location on the one hand and volume elements selected in a vicinity of the volume element containing the given location on the other hand, each volume element receiving a number of branch grains drawn from density data associated with this volume element, the orthotropic foam being built by connecting these branch grains to each other,
- the generator (4, 10) is also arranged to calculate a measurement between a first branch grain and a second branch grain from the distance between the location of the first branch grain on the one hand and the second branch grain on the other hand, by weighting this distance as a function of deformation data associated with the first branch grain and with the second branch grain,
- the generator (4, 10) is also arranged to select at least two branch grains for each branch grain, such that these at least two branch grains are the closest neighbors according to the measurement calculated by the generator (4, 10), and
- the generator (4, 10) is also arranged to define manufacturing data indicating that a location is full when the distance between said location and its projection on one of the branches linking each branch grain to its closest neighbors is less than a distance drawn from the radius data.

2. The device as claimed in claim 1, wherein the generator (4, 10) is also arranged to calculate the measurement between a first branch grain and a second branch grain by weighting it as a function of a frame of reference associated with the deformation data.

3. The device as claimed in claim 1 or 2, wherein the generator (4, 10) is arranged to select the closest neighbors of a given branch grain from among a subset of branch grains which excludes the branch grains whose locations are situated at a distance from the location of the given branch grain greater than a threshold drawn from the deformation data and from the number of closest neighbors sought.

4. The device as claimed in one of the preceding claims, wherein the generator (4, 10) is arranged to allocate the branch grains in a deterministic manner within each volume element.

5. The device as claimed in one of the preceding claims, wherein the generator (4, 10) is arranged to determine said branch grain locations by dividing each volume element of the plurality of volume elements into one or more volume sub-elements, the number of which is calculated from the density data and from the volume of each volume element, by pseudo-randomly determining, as a function of the location data and of the density data, volume sub-elements receiving a branch grain, and by pseudo-randomly determining, in each volume sub-element receiving a branch grain, branch grain data designating a location in this volume sub-element.

6. The device as claimed in one of claims 1 to 5, wherein the generator (4, 10) is a modeler (10) arranged to receive a triplet associating density data, deformation data and radius data, to determine a set of additive manufacturing data for an object of substantially cubic form from this pair, and to apply a homogenization method to draw a tensor datum therefrom.

7. The device as claimed in claim 6, wherein the modeler (10) is arranged, for a given triplet, to determine several sets of additive manufacturing data by varying the pseudo-random determinations, and to produce an average of the tensor data for the given triplet.

8. The device as claimed in one of claims 1 to 5, wherein the generator (4,10) is a constructor (4) arranged to receive object data (12) defining the form of an object to be produced by additive manufacturing and comprising tensor data associated with locations designated by the object data, and, for at least some of the locations of the object data, to determine deformation data, frame-of-reference data, radius data and density data from the associated tensor data, and to determine corresponding additive manufacturing data.

9. A method for manufacturing an orthotropic foam, **characterized in that** it comprises the following operations:

- receiving object data associating location data and tensor data, the tensor data being associated with density data, radius data and deformation data, and the location data designating a location and a volume element containing this location,

- determining branch grain locations in a plurality of volume elements, the number of branch grains in a given volume element being determined from the density data associated with the locations of the given volume element, the orthotropic foam being built by connecting these branch grains to each other,
- for each branch grain, calculating a plurality of measurements between this branch grain as first branch grain on the one hand and a second branch grain on the other hand, the second branch grain being chosen for each measurement from among the other branch grains, the measurement being calculated from the distance between the location of the first branch grain on the one hand and the second branch grain on the other hand, by weighting this distance as a function of deformation data associated with the first branch grain and with the second branch grain,
- selecting at least two branch grains for each branch grain, such that these at least two branch grains are the closest neighbors in the plurality of measurements calculated for each grain, and
- defining manufacturing data indicating that a given location is full when the distance between said given location and its projection on one of the branches linking each grain to its closest neighbors is less than a distance drawn from radius data, and
- manufacturing a foam according to the defined full locations.

10. The method as claimed in claim 9, wherein the measurement between a first branch grain and a second branch grain is weighted as a function of a frame of reference associated with the deformation data.

11. The method as claimed in claim 9 or 10, wherein, to select the closest neighbors of a given branch grain, the plurality of measurements is calculated with a subset of branch grains which excludes the branch grains whose locations are situated at a distance from the location of the given branch grain greater than a threshold drawn from the deformation data and from the number of closest neighbors sought.

12. The method as claimed in one of claims 9 to 11, wherein said branch grain locations are determined deterministically.

13. The method as claimed in one of claims 9 to 12, wherein said branch grain locations are determined by dividing each volume element of the plurality of volume elements into one or more volume sub-elements, the number of which is calculated from the density data and from the volume of each volume element, by pseudo-randomly determining, as a function of the location data and of the density data, volume sub-elements receiving a branch grain and by pseudo-randomly determining, in each volume sub-element receiving a branch grain, branch grain data designating a location in this volume sub-element.

14. The method as claimed in one of claims 9 to 13, wherein the foam manufacturing operation is performed by additive manufacturing.

**2**

**12**

**10** → **8** ← **4**

**6**

**14**

## Fig.1

HDR[] = Rand()   **200**

**210**   (H,d,r)=Pop(HDR)?   n → ( End )   **299**

**290** g++   y

**220** q=RandP(g)

**230** V=Til(GB,q,H,d,r)

g++   **260**

**280** i++   **240** TS[i]+=Hom(V)

**250** g<avgsd?   y

n

THDR[]+=Avg(TS[i]),H,d,r   **270**

## Fig.2

D ; q ; HF ; N=0    300

T[]=PN(q,HF)    310

320    (c;d)=Pop(T)?    n    340    B+=KNN(k,HF,N)

y

N+=SC(c,d)    End

330    399

## Fig.3

c ; d ; h=N=0    400

ijk=CI(c)    405

420    Dwn(ijk,h)    410    t=d*(ccl*2^-h)^3    465    Nxt(ijk)

t<8?    415

n

y

425    I[]=Rand(ijk)    499    End    n    460    h>0?

i=0    430    y

445    i++    435    i<t-1?    n    N+=RandLS(I[i],t)    455    Up(ijk)

y    450

N+=RandS(I[i])    440

## Fig.4

Fig.5

Fig.6

**Fig.7**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1652497

- FR 3038254 A1

**Littérature non-brevet citée dans la description**

- **ALLAIRE.** Shape optimization by the homogenization method. Springer Science & Business Media, vol. 146, G. 2012

- **MARTINEZ et al.** Procédural Voronoi foams for Additive Manufacturing. ACM TOG, 2016, vol. 35, 4